Europäisches Patentamt

European Patent Office

Office européen des brevets

(11) Publication number: **0 140 235**
**B1**

# EUROPEAN PATENT SPECIFICATION

(45) Date of publication of patent specification: **16.08.89**　　(51) Int. Cl.⁴: **G 11 C 7/00, G 11 C 11/40**

(21) Application number: **84112160.1**

(22) Date of filing: **10.10.84**

(54) Semiconductor memory device.

(30) Priority: **17.10.83 JP 193747/83**

(43) Date of publication of application:
**08.05.85 Bulletin 85/19**

(45) Publication of the grant of the patent:
**16.08.89 Bulletin 89/33**

(84) Designated Contracting States:
**DE FR GB**

(56) References cited:
**DE-A-2 711 221**
**US-A-3 798 621**
**US-A-4 104 719**
**US-A-4 193 128**
**US-A-4 347 585**
**IBM TECHNICAL DISCLOSURE BULLETIN, vol.
23, no. 4, September 1980, pages 1373-1374,
New York, US; R.J. PRILIK: "Shared random-
access memory and ROS functions by modified
random-access memory design"**
**INTEL MARKETING COMMUNICATIONS, "The
semiconductor memory book" 1978, pages
294-300, John Wiley & Sons, New York, US;
B.GREENE: "Designing with 2708 EPROM"**

(73) Proprietor: **KABUSHIKI KAISHA TOSHIBA
72, Horikawa-cho Saiwai-ku
Kawasaki-shi Kanagawa-ken 210 (JP)**

(72) Inventor: **Tominaga, Masashi C/O Patent
Division
KABUSHIKI KAISHA TOSHIBA 1-1 Shibaura
1-chome
Minato-ku Tokyo 105 (JP)**
Inventor: **Hayashi, Hiromasa C/O Patent
Division
KABUSHIKI KAISHA TOSHIBA 1-1 Shibaura
1-chome
Minato-ku Tokyo 105 (JP)**

(74) Representative: **Henkel, Feiler, Hänzel & Partner
Möhlstrasse 37
D-8000 München 80 (DE)**

Courier Press, Leamington Spa, England.

## Description

This invention relates to an improved semiconductor memory device which can alter, under external control, the contents of a static type random access memory (RAM), particularly, at a specific time during an operation.

Prior art document US—A—3 798 621 discloses a monolithic storage array comprising a plurality of symmetrical bistable storage cells. A controllable switching element is connected to one side of a cell for providing a predetermined asymmetry during personalization of said cells as read-only elements. Further a symmetrical impedance element is connected at the respective other side of said storage cells for maintaining the overall impedance symmetry of said storage cells during read/write operation. In this way, the bistable storage cells can be operated both as read/write storage elements and read-only storage elements.

Further, prior art document DE—A—2 711 221 describes a semiconductor memory device comprising a plurality of memory cells which constitute a memory matrix array. In this memory device at least one pair of variable threshold field-effect transistors for storing non-erasable data are connected to the bistable output point of a bistable circuit for storing erasable data.

Prior art document US—A—4 347 585 discloses a reproduce-only storage matrix comprising rows and columns of conductors. A relatively high barrier Schottky diode connects a respective row conductor to a respective column conductor at each matrix crossover at which a stored binary number of a given value is desired, and a relatively low barrier Schottky diode is connected to a respective column conductor for selecting said column, said low barrier Schottky diode being rendered conductive only when its respective column is unselected.

Further, prior art document US—A—4 193 128 describes a high-density memory with a nonvolatile storage array. In this memory a memory sub-array has a single volatile memory cell and an array of nonvolatile memory cells. The volatile memory cell includes a static flip-flop circuit and each memory cell of the nonvolatile memory cell array includes a pair of nonvolatile memory transistors that store information in accordance with the state of the transistor threshold voltage.

As a semiconductor memory for the conventional microcomputers etc., use is made of a specific combination of a read only memory (ROM) for storing fixed data, such as an erasable, programmable ROM (EPROM) or a mask ROM, on one hand, and a (RAM) for storing variable data, such as a static RAM or a dynamic RAM, on the other hand. The conventional nonvolatile RAM, such as an MNOS (metal nitride/oxide semiconductor) RAM, can reproduce a state corresponding to a power-off state when the power is on, but does not reproduce any mask pattern (data pattern). The conventional static RAM is in an unstable memory state upon the closure of a power source and holds given data at a data loading time. The conventional ROM is dedicated to data readout only and cannot have its memory data erased even partially for new data.

With this situation, there is an urgent need for a semiconductor memory device which permits the memory contents of a RAM or a ROM to be altered, as required, at an arbitrary time during operation.

It is accordingly the object of this invention to provide a new and improved semiconductor memory device which can alter, under external control, its memory contents at any arbitrary point of time during operation.

The present invention provides a semiconductor memory device with read/write and preset functions comprising:

—a plurality of semiconductor memory cells each including a flip-flop for storing data, respectively;

—a plurality of data input/output lines connected to said plurality of semiconductor memory cells respectively, for effecting an input/output operation with respect to each memory cell, and

—a plurality of control lines, said semiconductor memory device being characterized in that:

—each semiconductor memory cell includes one pair of switching elements which is connected between the pair of nodes of each flip-flop, respectively, and reference potential, and

—each one of said plurality of control lines is connected via a diode to the control input of one of the switching elements.

This invention can be understood by reference to the accompanying drawings in which:

Fig. 1 is a circuit arrangement showing a semiconductor memory device useful for the understanding of embodiments of this invention, the semiconductor memory device being shown as applied to a static memory; and

Figs. 2 and 3 each are circuit arrangements showing different embodiments of this invention.

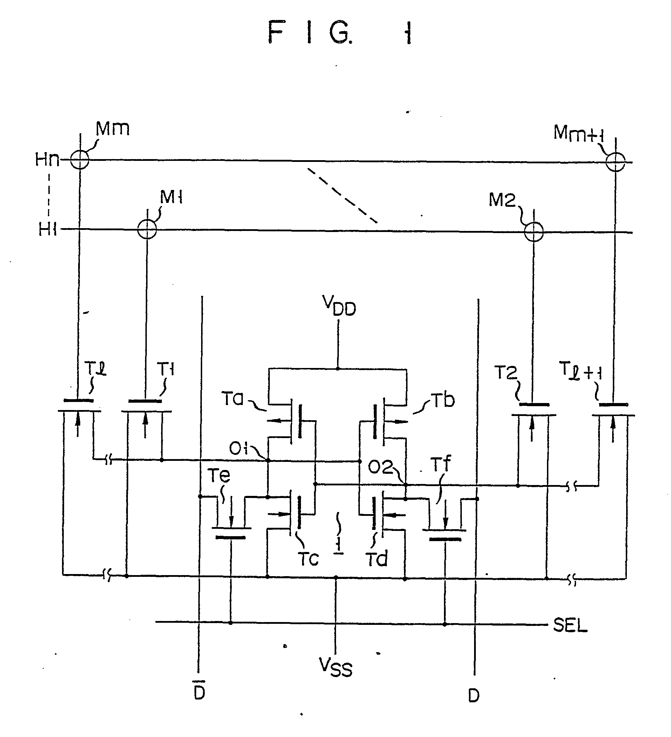

In Fig. 1, transistors Ta to Tf show metal oxide semiconductor field effect transistors MOSFETs (hereinafter referred to merely as MOS transistors) which comprise a binary logic circuit (a bistable circuit), such as a flip-flop circuit. MOS transistors T1 and T2 . . . , and Tl and $T_{l+1}$ are semiconductor switching means whereby a plurality of data which is prepared to alter memory contents is selectively called to a memory cell used, for example, in a RAM. H1 . . . and Hn show input control lines prepared to alter the memory contents, such as to have a given data pattern, as will be described later. M1 and M2 . . . , and Mm and $M_{m+1}$ are selective junctions between the gates of the MOS transistors on one hand and the control lines H1 . . . Hn on the other hand. In this connection it is to be noted that one of the selective junctions M1 and M2 is electrically connected, and the other selective junction is not electrically connected. In this way, the same connection is made up to the selective junctions Mm and $M_{m+1}$, that is, with one selective junction Mm or $M_{m+1}$ electrically connected and the other selective junction not electrically connected. First memory contents altering data is prepared for the memory cell 1 through the control line H1. In this way, nth memory contents altering data is prepared for the corresponding memory cell through the control line Hn. D and $\bar{D}$ show data input/output lines for the memory cell 1, and SEL shows a data input/output select line for the memory cell 1.

The above-mentioned memory cell 1 is designed for a one-power source 6-element 3-line type static memory. Here, MOS transistors Ta and Tb for loading have their drain electrodes connected to a first power source $V_{DD}$, their source electrodes connected to first and second output terminals O1 and O2, respectively, and their gate electrodes connected to the second and first output terminals O2 and O1, respectively. The MOS transistors Tc and Td for a flip-flop circuit have their drain electrodes connected to the first and second output terminals O1 and O2, respectively, their source electrodes commonly connected to a second power source terminal $V_{ss}$ (normally a ground level) and their gate electrodes connected to the second and first output terminals O2 and O1, respectively. The MOS transistors Te and Tf for a gate circuit have their drain electrodes connected to the data input/output lines $\bar{D}$ and D, respectively, their source electrodes connected to the first and second output terminals O1 and O2, respectively, and their gate electrodes commonly connected to the data input/output select line SEL.

The MOS transistors T1 and T2 . . . , and Tl and $T_{l+1}$ as switching means have those drain electrodes at the left side connected to the first output terminal O1 and those drain electrodes at the right side of Fig. 1 connected to the second output terminal O2; their source electrodes commonly connected to the second power source terminal $V_{ss}$, and their gate electrodes connected to the control lines H1 . . . , and Hn so as to satisfy the above-mentioned requirements.

The arrangement of Fig. 1 shows a one-bit memory device, but in actual practice use is made of a multi-bit IC memory device having a plurality of memory cells 1 corresponding to a like number of bits with the control lines H1 . . . , and Hn similarly connected in the relation mentioned.

The operation of the semiconductor memory device as shown in Fig. 1 will be explained below.

Now suppose that the control lines H1 . . . , and Hn are at the "0" (lower) level, that is, no memory contents altering data items are supplied to the control lines. Since the switching MOS transistors T1 and T2 . . . , and Tl and $T_{l+1}$ are all nonconductive, the memory cell 1 operates as an ordinary static memory. Suppose also that the memory content of the memory cell 1 is at a "0" state with the MOS transistor Td at an "ON" level and the transistor Tc at an "OFF" level in the flip-flop circuit. In order to store a level "1" into the memory cell so as to reverse the above-mentioned state, for example, a voltage going from a negative to a positive direction is applied to the data input/output line $\bar{D}$ and a positive-going voltage is applied to the data input/output select line SEL. As a result, the MOS transistors Te and Tf for the gate circuit are rendered conductive with the MOS transistor Tc being on and the MOS transistor Tf being off. When the data input/output select line SEL goes back to a negative voltage level, the MOS transistors Te and Tf are turned off. The data input/output line $\bar{D}$ goes back to a negative voltage level. This means that a level "1" has been stored in the memory cell.

In order to read the memory content "1" out of the memory cell 1, for example, a pulse voltage is applied on the data input/output select line SEL only. In this way, the potential on the output terminal of the flip-flop circuit, e.g., a read signal, is output to the data input/output lines $\bar{D}$ and D.

Suppose that a plurality of memory cells 1 is prepared to correspond to a like plurality of bits. As is well-known in the art, an X (address) decoder and Y (address) decoder, not shown, are arranged with respect to the data input/output select line SEL and data input/output lines $\bar{D}$ and D to obtain a RAM.

Let it be assumed that, for example, a "1" (high) level is supplied, as first data for altering the memory content, to the control line H1 during the operation of the static memory (RAM). If, in this case, the selective junction M1 is electrically connected, the MOS transistor T1 is turned on, causing a "0" level to appear on the first output terminal O1 to permit the memory cell 1 to suffer a forced data reversal. If the selective junction M2 is electrically connected, the switching transistor T2 is turned on, causing a level "0" to appear on the second output terminal O2 to permit the memory cell 1 to suffer a corresponding forced data reversal. In this way, if data items are prepared with respect to the second n-th control lines H2 to Hn, the corresponding memory cells similarly experience a corresponding data reversal to permit the memory contents to be altered.

From the above it will be appreciated that the content of the memory cell 1, that is, that of the static memory can be altered under external control by supplying memory contents altering data at any arbitrary time point of an operation including a time immediately subsequent to the closure of the power source. Where in particular a plurality of memory cells 1 is prepared, the contents of the memory cells can be so altered as to have a predetermined system program or a given mask pattern (data pattern) which has been set to correspond to the respective bits.

With such a matrix array of selective junctions given as a ROM configuration, the level of the respective selective junctions in the ROM configuration is selectively read onto a corresponding one of the bit memory cells in a RAM configuration through the corresponding one of the switching MOS transistors T1 and T2 . . . , and Tl and $T_{l+1}$ to permit this arrangement to be used for a mask ROM. This arrangement has a combined RAM/ROM feature, thus reducing the requisite number of circuits in comparison with the case where a RAM and ROM are used separately. It is therefore possible to mount IC elements in a high packing density on a printed circuit board.

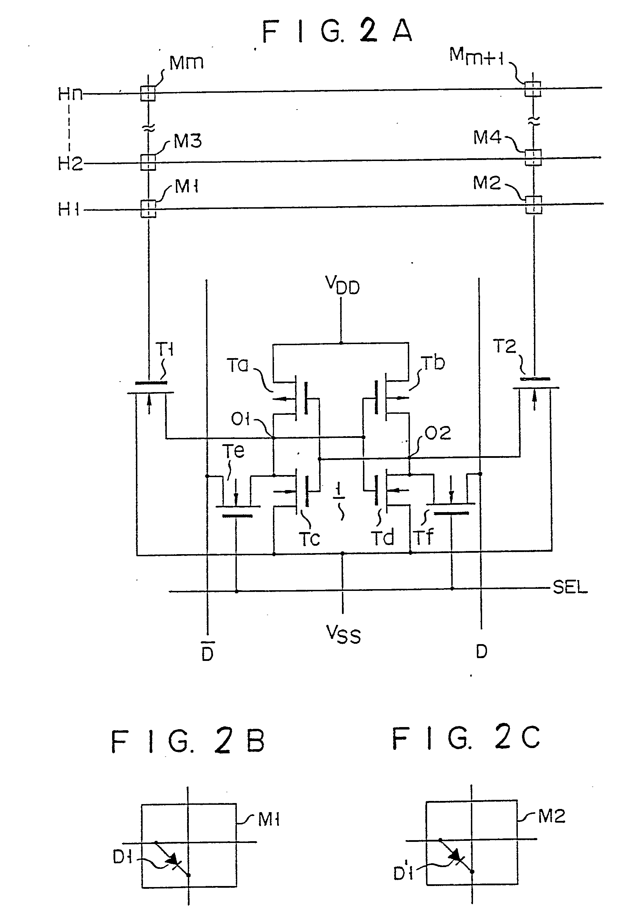

Fig. 2A shows an arrangement of a complementary MOS (CMOS) type static memory using selective junctions M1 to $M_{m+1}$ on the gate lines of transistors T1 and T2, and using control lines H1 to Hn as a diode matrix array. This arrangement is similar to that of Fig. 1 except for the above-mentioned matters. The selective junctions M1 and M2 are arranged such that with the diode D1 present on the junction M1 as shown in Fig. 2B the diode on the junction M2 is omitted and that with the diode absent on the junction M1, on the other hand, a diode D1' as shown in Fig. 2C—which is similar to the diode D1—is provided on the selective junction M2. In this way, the remaining selective junctions M3 and M4 . . . Mm and $M_{m+1}$ are arranged to have the relation set out above.

The arrangement as shown in Fig. 2A can be used as an ordinary static memory (RAM) because with the control lines H1 to Hn at the "0" level, the MOS transistors T1 and T2 are turned off as in the case of the arrangement shown in Fig. 1. With respect to the control line H1 set to "1" and the diode D1 present on the selective junction M1, for example, the MOS transistor T1 is turned on and a "0" level appears on the output terminal O1 to permit the memory cell 1 to be correspondingly set. With the diode D1' present on the selective junction M2, on the other hand, the MOS transistor T2 is turned on and a "0" level emerges to permit the memory cell to be correspondingly set.

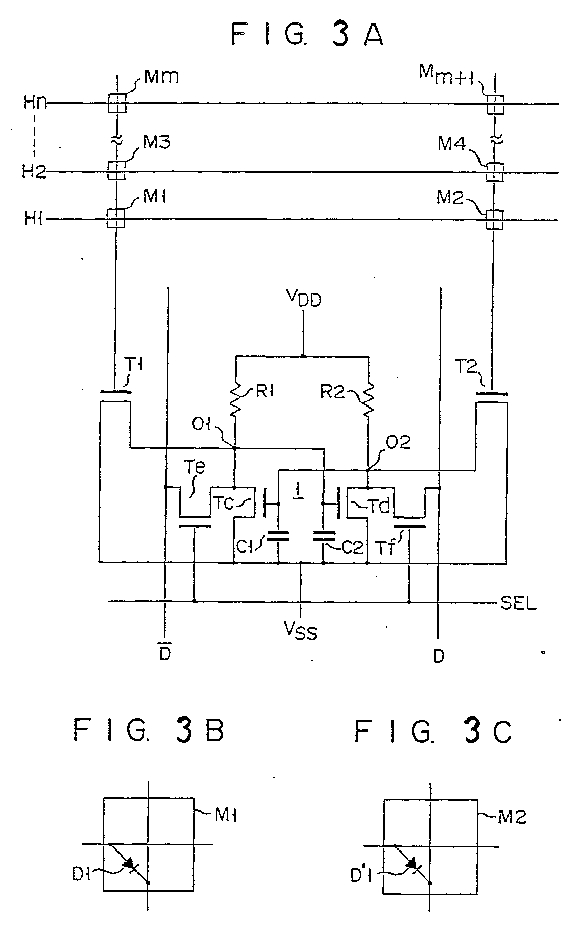

Figs. 3A to 3C show an arrangement of an n-channel MOS type static memory. This arrangement is similar to that of Fig. 2A except for the replacement of all the transistors of Fig. 2 by N-channel MOS type transistors and the new addition of load resistors R1 and R2, and capacitances ·C1 and C2. The operation of Fig. 3 is similar to that of Fig. 2 with respect to function.

A desired number of control lines and memory contents which alter data may be provided according to the purpose for which the semiconductor memory device is used. The same thing can be applied to a semiconductor memory device for a plurality of bits.

As evident from the above, according to this invention an improved semiconductor memory cell is provided which can alter memory contents at any arbitrary time point of an operation.

## Claim

A semiconductor memory device with read/ write and preset functions comprising:
—a plurality of semiconductor memory cells each including a flip-flop for storing data, respectively;
—a plurality of data input/output lines (D, $\bar{D}$) connected to said plurality of semiconductor memory cells (1), respectively, for effecting an input/output operation with respect to each memory cell (1), and
—a plurality of control lines ($H1, \ldots, H_n$), characterized in that
—each semiconductor memory cell includes one pair of switching elements ($T_1$, $T_2$) which is connected between the pair of nodes (O1, O2) of each flip-flop, respectively, and reference potential ($V_{SS}$), and
—each one of said plurality of control lines ($H_1, \ldots, H_n$) is connected via a diode (D1, D1') to the control input of one of the switching elements ($T_1$, $T_2$).

## Patentanspruch

Halbleiterspeicheranordnung mit Lese/Schreib- und Voreinstellfunktionen mit:
—einer Vielzahl von Halbleiterspeicherzellen, deren jede jeweils ein Flipflop zum Speichern von Daten hat,
—einer Vielzahl von Dateneingangs/Ausgangsleitungen (D, $\bar{D}$), die jeweils mit der Vielzahl von Halbleiterspeicherzellen (1) verbunden sind, um eine Eingabe/Ausgabeoperation bezüglich jeder Speicherzelle (1) zu bewirken, und
—einer Vielzahl von Steuerleitungen ($H_1, \ldots, H_n$), dadurch gekennzeichnet, daß
jede Halbleiterspeicherzelle ein Paar von Schaltelementen ($T_1$, $T_2$) hat, das jeweils zwischen dem Paar von Knoten (O1, O2) jedes Flipflops und einem Bezugspotential ($V_{SS}$) liegt, und
jede eine Steuerleitung der Vielzahl von Steuerleitungen ($H_1, \ldots, H_n$) über eine Diode (D1, D1') mit dem Steuereingang eines der Schaltelemente ($T_1$, $T_2$) verbunden ist.

## Revendication

Dispositif de mémoire à semi-conducteur avec des fonctions de lecture/écriture et de mise en place préalable comportant:
—plusieurs cellules de mémoire à semi-conducteur comportant chacune un circuit bistable pour mémoriser des données respectivement,
—plusieurs lignes d'entrée/sortie des données (D, $\bar{D}$) connectées auxdites plusieurs cellules de mémoire à semi-conducteur (1) respectivement pour effectuer une opération d'entrée/sortie par rapport à chaque cellule de mémoire (1), et
—plusieurs lignes de commande ($H_1, \ldots H_n$), caractérisé en ce que
—chaque celle de mémoire à semi-conducteur comporte une paire d'éléments de commutation ($T_1$, $T_2$) qui est connectée entre la paire de points communs (O1, O2) de chaque circuit bistable respectivement et un potentiel de référence ($V_{SS}$), et
—chacune desdites plusieurs lignes de commande ($H_1, \ldots H_n$) est connectée, par une diode (D1, D1'), à l'entrée de commande de l'un des éléments de commutation ($T_1$, $T_2$).

F I G. 1

EP 0 140 235 B1

# F I G. 2 A

# F I G. 2 B

# F I G. 2 C

# F I G. 3 A

# F I G. 3 B

# F I G. 3 C